Europäisches Patentamt

European Patent Office

Office européen des brevets

(19)

(11) EP 0 426 523 B1

## (12) EUROPEAN PATENT SPECIFICATION

(45) Date of publication and mention
of the grant of the patent:
**26.02.1997 Bulletin 1997/09**

(51) Int Cl.⁶: **G03F 7/20**

(21) Application number: **90402913.9**

(22) Date of filing: **17.10.1990**

(54) **Direct Write Film plotting method and apparatus**

Plotter-Verfahren und -Vorrichtung für direkt beschreibbaren Film

Méthode et appareil de traçage sur un film à écriture directe

(84) Designated Contracting States:
**DE FR GB**

(30) Priority: **03.11.1989 IL 92207**

(43) Date of publication of application:
**08.05.1991 Bulletin 1991/19**

(73) Proprietor: **ORBOTECH LTD.
Nes Ziona 70450 (IL)**

(72) Inventors:
- **Barak, Shlomo
  Rishon Lezion 75258 (IL)**
- **Gross, Abraham
  Rehovot (IL)**
- **Malinovich, Yokov
  Rishon Lezion 75264 (IL)**

(74) Representative: **Gutmann, Ernest et al
Ernest Gutmann - Yves Plasseraud S.A.
3, rue Chauveau-Lagarde
75008 Paris (FR)**

(56) References cited:
**DE-A- 2 951 705          US-A- 4 211 838**

- **CHEMTRONICS, vol. 4, no. 309, September 1989,
  Guildford GB, pages 197-201 ; M.E. GROSS :
  'Laser direct-write metallization in thin
  metallorganic films'**
- **FEINWERKTECHNIK + MESSTECHNIK, vol. 92,
  no. 5, July 1984, Munich DE, pages 229-230 ; J.
  PEHRS : 'Laser-Belichtung für die
  Leiterplatten-Fertigung'**

## Description

## FIELD OF THE INVENTION

The present invention is in the field of automatic plotting on a so-called direct write film. The invention serves, among others, for the fabrication of masks also referred to in the art as phototools, which are used in the production of printed circuit boards.

## LIST OF ABBREVIATIONS

In the following description some abbreviations will occasionally be used which have the following meanings:

AO         - acousto optical
CAD       - computer aided design
DI            - direct imaging
DWF       - direct write film
LCLV      - liquid crystal light valve
LD           - laser diode
PCB        - printed circuit board.

## BACKGROUND OF THE INVENTION AND PRIOR ART

One of the crucial steps in photographic production of desired patterns such as in PCBs, on a so-called photoresist plate, is the creation of a phototool film. In PCB manufacture, for example, the phototool is needed for imaging the data onto the board, usually by selective exposure of the phototool to ultraviolet light, shone through the phototool. There are some disadvantages in the commonly used techniques for the fabrication of phototools. Thus the production of a normal silver halide phototool involves data transfer to a photographic film by image-wise exposure in a photoplotter and immersing a photographic film in various liquids. This inevitably involves handling of the films, either manually or automatically. The film developer needs fine tuning and online control in order to avoid major defects. Chemical waste and chemical consumables are involved and generally a dark room is needed. The film must be stabilized for several hours both before and after developing, to avoid dynamic size changes and to bring the film to the correct size under defined environmental conditions. The developing step itself takes a few minutes. Lastly, there is no way to verify on line the reliability of the data transfer to the photographic film in the photoplotter.

It is also known to produce a phototool by DI techniques. Here electronically stored data such as CAD data, are written in two different ways: Directly on the photoresist as raster data such as by the Excellon Photonics Technology (See Print. Circuit. Fabr. (USA), vol. 11, no. 1, P 50, 52-3, 55, 113-17, Jan. 1988) or by utilizing LCLV technology (See US patent No. 4,799,770 and US patent No. 4,818,098). DI technology can eliminate the need for any consumable phototools but still has serious limitations: Fabrication is in a red-light room, there is need for a special, high cost photoresist sensitive to visible (mostly blue-green) light and there are difficulties with the life time and reliability of the laser tube, where one is used. Writing the data directly using the raster method takes a long time. The use of the LCLV technology also takes a long time, since vector rather than raster scanning is used.

It is the object of the present invention to provide a method and apparatus for producing a phototool by means of a modified DI technology which overcomes the problems associated with both the fabrication of conventional silver halide based phototools and known DI methods.

## SUMMARY OF THE INVENTION

The invention makes use of DWF's of the type comprising a metal/metal compound layer, supported on a transparent base, such as disclosed, for example, in US. 4,211,838; 4,242,439 and 4,332,880, in a new and original way.

The invention provides a Direct Write Film plotting method according to claim 1. Preferred embodiments of the method are defined in dependent claims 2 to 6.

The invention is applicable for the fabrication of phototools from DWFs of the kind specified for any desired purpose, a typical application being the production of PCBs.

If desired, a phototool fabricated in accordance with the invention may be used for a plurality of exposures.

In accordance with the invention verification of the DWF is performed on line by direct comparison of plotted data with the reference data, e.g. CAD data. Furthermore, in accordance with the invention all the problems and defects associated with wet development processes as well as with known DI processes are avoided.

Moreover, due to the fact that the DWF employed in accordance with the invention is of the type in which a metal/metal compound layer is supported on a transparent base, a further significant advantage is achieved where the resulting phototool is used for the production of PCBs. It is known that in a regular silver halide mask the black areas absorb radiation during exposure and the radiant energy absorbed can warm the mask and affect the image quality. The equivalent of opaque areas on the DWF employed in accordance with the invention, i.e. those areas that do not transmit light, due to their metallic nature do in fact reflect light rather than absorb it and thus help keep the film stable during exposure whereby an accurate and consistent exposure is achieved.

Where the phototool according to the invention is used for the production of FCBS, the fabrication thereof is preferably combined with the PCB production in that the phototool obtained in the manner specified is fed directly into a further operational step in which a photosensitive plate is exposed to light transmitted through the phototool and the so-exposed photo-sensitive plate is then developed.

Where the photosensitive plate is to be exposed on both sides it will be turned over after a first exposure and subjected to a second exposure with the intermediary of the same or a different, similarly produced phototool.

The invention further provides a Direct Write Film system according to claim 7. This system may be part of a system for manufacturing printed circuit boards (claim 13). Preferred embodiments of these systems are defined in dependent claims 8 to 12, and 14 to 17.

The exposure of a photosensitive plate to light via a phototool prepared in accordance with the invention may be by contact or off-contact. Where the exposure is off-contact it may be with or without enlargement. Off-contact exposure has the advantage of enabling enlargement where it is desired and also makes it possible to eliminate accumulation of defects on the phototool such as scratches, dust or other contaminations.

Unlike in conventional DI raster methods, in accordance with the invention there is no need for a high power UV or visible laser source. It is moreover possible to select a particular phototool material in accordance with specific requirements from amongst the relatively large group of films consisting of a metal/metal compound layer supported on a transparent base.

Where in the method and system according to the invention the plotter head comprises a plurality of LDs, the reading head of the associated verification assembly will preferably comprise an equal number of LDs with each LD of the plotter head having a co-ordinated LD in the reading head.

## DESCRIPTION OF THE DRAWINGS

For better understanding a specific embodiment of the invention will now be described, by way of example, with reference to the annexed drawings, it being understood that the invention is not limited thereto. In the drawings:

Fig. 1 is a block diagram of the performance of the method according to the invention;
Fig. 2 is a schematic illustration of a plotter apparatus with associated verification unit according to the invention;
Fig. 3 is a schematic perspective illustration of an LD array in a plotter head of an apparatus according to the invention;
Fig. 4 is a schematic illustration of a reading head in a verification assembly of a plotter apparatus according to the invention;
Fig. 5 is a schematic plan view of a micropositioner carriage of a plotter apparatus according to the invention;
Fig. 6 is a section along line VI-VI of Fig. 5, drawn to a larger scale; and
Fig. 7 is a schematic illustration of an exposure device forming part of an integrated PCB production apparatus according to the invention.

## DETAILED DESCRIPTION OF A PREFERRED EMBODIMENT

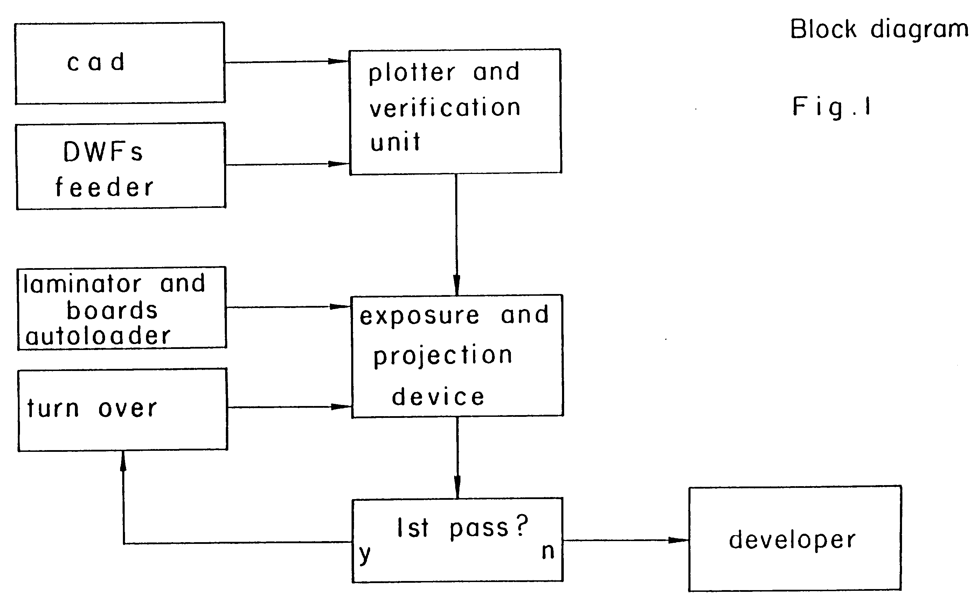

As seen in Fig. 1, the main features in the present invention are the plotter and the exposure device. Raster data are sent to the plotter from a workstation like a CAD and archiving system. An autoloader feeds the plotter intermittently with fresh DWFs. Plotting and verification are done at the same place and in the same moment, and a properly imaged film is sent to the exposure device while a faulty one is discarded. Photosensitive plates, such as boards for PCBs, are sent to the exposure device after lamination. In one option, if the board was exposed on one side, it is then, turned over and sent back for exposing the same or a different image on the back side. Exposure of both sides at the same time is also possible. After the second pass the printed board moves to a developer.

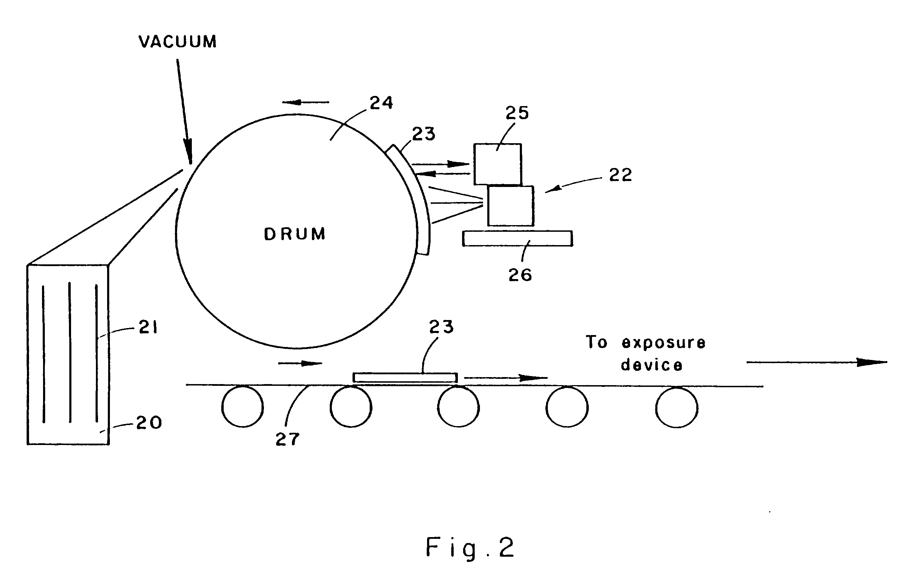

Fig. 2 shows the main features of the plotting device. A cassette 20 with fresh DWFs 21 is connected to the plotter head 22 as known per se, and the loading operation is done fully automatically. A film 23 of the kind in which a metal/metal compound layer is supported by a transparent base, is held on a drum 24 by a vacuum. The drum 24 rotates anticlockwise at, say, 500 rpm. Data are plotted on the film by a fan of laser rays that emerge from a LD array in plotter head 22; A reader head 25 that forms part of a verification assembly is located above plotter unit 22 such that the reading head 25 scans a film 23 directly upon writing by plotter head 22. The verification assembly further includes a controller unit (not shown) which is fed with data from a DWF cassette and is electrically linked to both the reading head 25 and plotter head 22 so that primary signal from the former are inputted into the controller unit and secondary signals are generated in the latter when the writing of the plotter head deviates from the design pattern. The said secondary signals may be used for producing optical or acoustic alarm signals, or else for actuating an automatic rejection mechanism.

The plotting head 22 and the reading head 25 are mounted on a micropositioner carriage 26 that moves horizontally on a track, as the data are plotted. The plotting speed is variable and is automatically adjusted to local complexity, as like as in the Optrotech plotter LS5008 (see: Printed Circuit Design, vol. 6, no. 9, p. 8 and p. 46, September 1989). After plotting, the vacuum is released and the film 23 is received by a conveyer 27 and is moved by the latter to an exposure device.

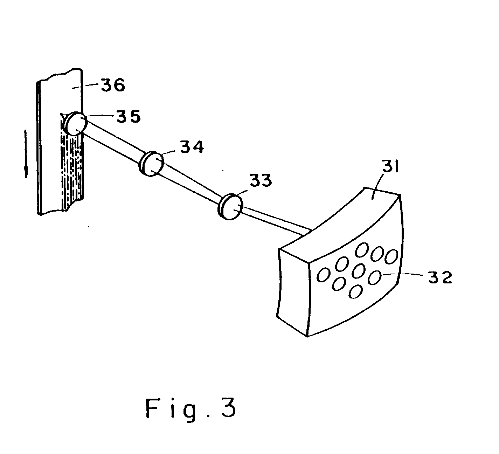

Fig. 3 shows a two-dimension LD device of the type disclosed in US patent No. 4,743,091 and which is used for writing the data on the DWF. It includes a casing 31, an LD array 32 which has a set of collimating lenses for each diode (not shown). Lenses 33, 34, 35 project the LD array on the DWF 36 which is located behind the lens 35.

The total power P needed for writing is given by:

$$P = (S/M*M)*E*Ef/T$$

where S is the area of the photosensitive plate, M is a one-dimensional magnification factor, E is the exposure energy needed for the DWF, Ef is an efficiency factor and T is the total exposure time for one film. Ey way of an example, in PCB production, P is approxrnately 500 mW for S=24*30*5.4 cm$^2$, M=5, E=200 mJ/cm$^2$, T=300 sec and ef=3 which are typical numbers. The LD array can be based on 5 powerful 100 mW LDs, or on more, less intense LDs, say 32 of 20 mW each. The data that transfer to each diode is delayed according to the diode's position in the array. Each LD, when operated, creates a 3 micrometer diameter spot.

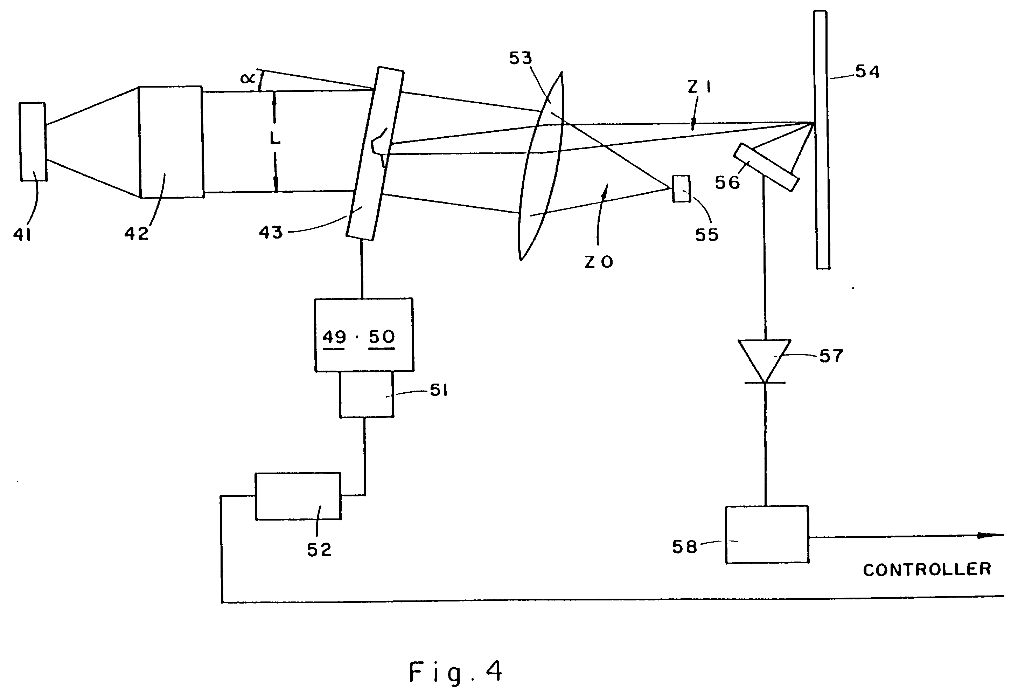

Fig. 4 shows the design of reading head 25 which is based on a pixel-by-pixel scanning of the written DWF. By way of example, an array of LAs like the one that is used in the plotter head 22 can also be used with equal number of diodes in both, with each writing diode having its own detector diode. Here a low intensity LD 41 such as Melles Griot 5 mW LD emits a laser beam that pass through a cylindrical lens 42. This shapes the beam to an elliptical shape with length L and width W. The length L depends on the number of the diodes in the LA array, and it is equal to the diameter of the dot times the number of resolution elements in an AO cell 43 times an overlapping factor. (It is 2.8 mm for a 32 LD array, for example). The beam approaches the AO cell 43, which may, for example, comprise TeO2 crystals, at the appropriate Bragg angle α. An acoustic pulse is generated in the AO cell by a driver 49 in RE frequency, (say 200 MHz). This driver is synchronized with the drum rotation and with the plotting unit 22 by a circuit that includes a timer 52, a pulser 51 and a AM modulator 50. The acoustic pulse moves in the AO cell at the speed of sound (4200 m/sec), and diffracts some of the incident beam to produce a so-called first order beam Z1. The Z1 beam is demagnified by a microscope lens (or a set of lenses) 53 by a factor of approximately 70, and accordingly any microscope objective can be used. A scanning spot (the image of the AO modulator) is created on the (written) DWF 54. The non-diffracted main part of the beam, the so-called zero order (ZO), is blocked by a shutter 55 at the focal plane of the lens 53 behind the AO cell. The Z1 beam is reflected from the DWF at an angle equal to the incident angle and collected by a wide-angle lens and a PIN silicon detector 56 to an electronic set-up that include preamplifier 57 and a threshold device 58. This set-up sends a binary signal, according to the amount of radiant energy that reflected form the DWF, to a controller (not shown).

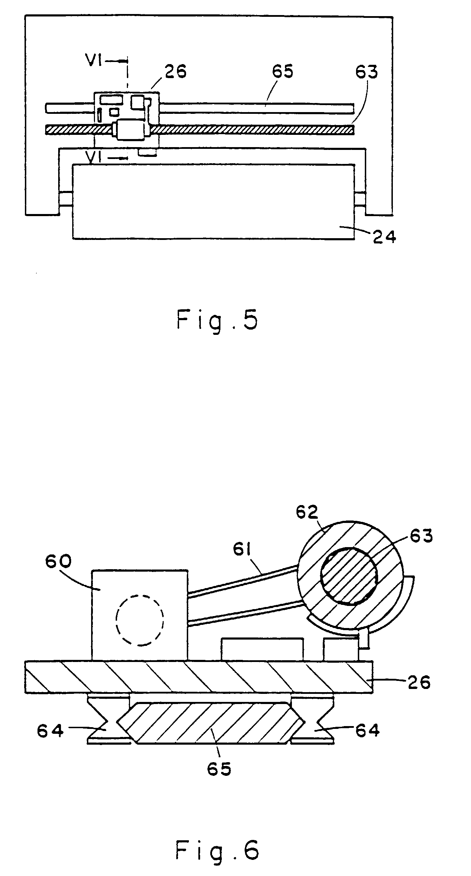

Figs. 5 and 6 show the essential features of the micropositioner carriage. As shown, the micropositioner carriage 26 carries a stepper motor 60 that drives a nut 62 via a belt 61. Nut 62 winds on a lead-screw 63. The micropositioner carriage 26 is fitted with wheels 64 which engage a track 65 and in this way smooth horizontal movement is achieved in parallel to the axis of drum 24.

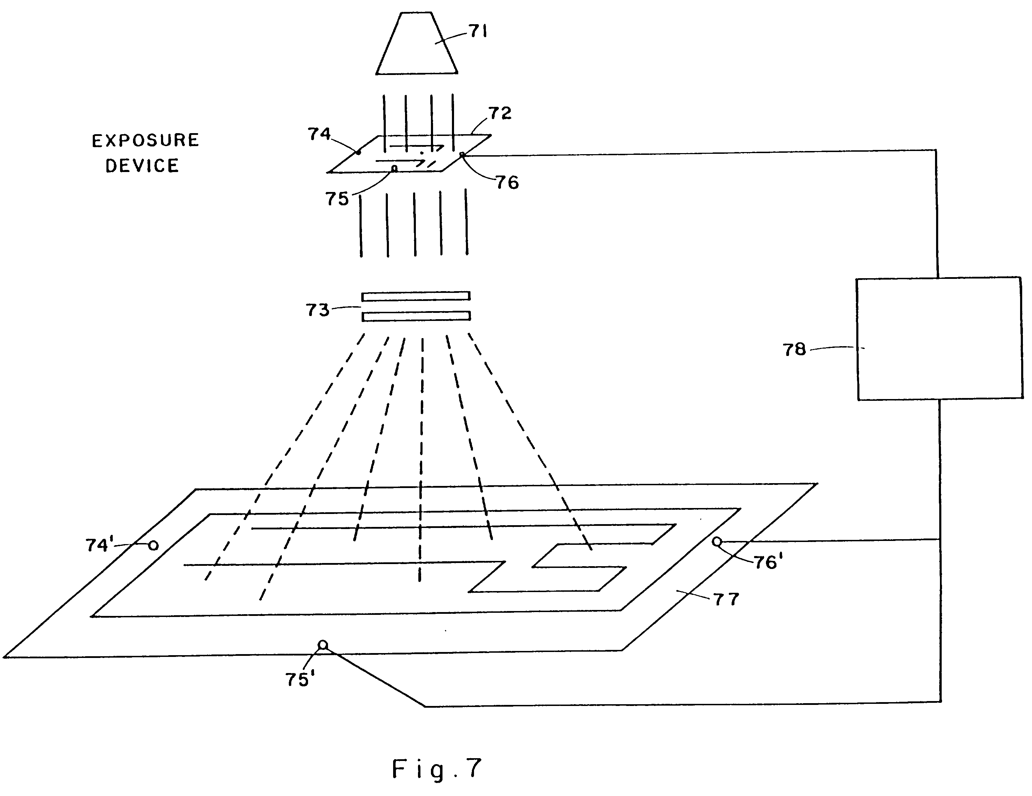

Fig. 7 shows the main features of an exposure device that forms part of an integrated PCB production apparatus according to the invention. Light from a source 71 is flashed onto a phototool 72 (the written film) fabricated in accordance with the invention and an optical set-up comprising lenses 73 projects the enlarged image onto a photosensitive plate 77 attached tightly to a flat table by a vacuum. Three dots on the phototool 74, 75, 76 are used for registration. The images 74′, 75′, 76′ of these dots fail on the table, at suitable locations, and a computerized feedback device 78 controls the corrections of the phototool position, by movements in the x, y or "teta" (rotation) directions.

## Claims

1. A Direct Write Film plotting method, particularly for fabricating a phototool (72) of the kind wherein electronically stored reference data are plotted on a Direct Write Film (21) comprising a metal/metal compound layer supported on a transparent base so as to write pixel data on the film representative of the reference data, CHARACTERIZED BY THE STEPS OF:

    reading the written pixel data on-line directly after it has been plotted on the Direct Write Film; and
    comparing on-line the pixel data with the reference data so as to verify that the step of imaging is error-free.

2. The method according to Claim 1, further characterized by the step of rejecting any film for which the step of imaging is not verified as error-free.

3. The method according to Claim 1, further characterized by the steps of:

    producing an alarm signal in respect of any film for which the step of imaging is not verified as error-free, and
    removing said film manually.

4. The method according to Claim 1, further characterized by the steps of:

    producing an alarm signal in respect of any film for which the step of imaging is not verified as error-free, and

removing said film automatically.

5. The method according to any one of the precedings claims, wherein the Direct Write Film is imaged by means of a laser diode.

6. The method according to any one of the preceding claims, characterized by the further steps of:

exposing a photo-sensitive plate to light transmitted through a prefabricated film, and developing the exposed photo-sensitive plate.

7. A Direct Write Film system, particularly for fabricating a phototool (72), the system comprising:

reference means (CAD) for providing reference data to be written on the Direct Write Film, a cylindrical support surface (24) for supporting a Direct Write Film (23) thereon, writing means (22) coupled to the reference means and responsive to the reference data for writing pixel data representative of the reference data on to the Direct Write Film, and displacement means (26) coupled to the writing means for displacing the writing means (22) relative to the support surface and in synchronization with rotation therefore; and characterized in that it comprises a verification assembly comprising: a reading head (25) coupled to the displacement means (26) for reading the pixel data online directly after it has been written by the writing means, said reading head including:

a laser light source (41) for producing a beam of light, and scanning means (49, 50, 51, 52) for scanning the beam of light over the Direct Write Film so as to read the written data.

8. The system according to Claim 7, characterized in that the verification assembly comprises a controller unit for comparing the pixel data to the reference data so as to generate an error signal if the pixel data does not correspond to the reference data.

9. The system according to Claim 7, characterized in that said writing means (22) include

imaging means (32) for imaging a Direct Write Film, and a plotter head coupled to the reference means and to the imaging means for modulating the imaging means in accordance with said reference data.

10. The system according to Claim 9, wherein said imaging means is a source of laser light.

11. The system according to Claim 7, wherein the controller unit includes:

a threshold comparator (58) for comparing the optical density of the reflected beam with respective low and high thresholds depending on whether the beam of light strikes a dark or a clear area of the Direct Write Film.

12. The system according to Claim 7 or 8, further including a rejector means coupled to the verification assembly and responsive to the error signal for automatically rejecting a faulty film.

13. A system for manufacturing printed circuit boards (77), comprising :

a Direct Write Film plotting system according to claim 7, a photosensitive medium (77) to which a design pattern is to be transferred, an exposure unit (71) for exposing the photosensitive medium through the film or phototool (72), transport means for transporting the phototool, after fabrication thereof, from the support surface (24) to the exposure unit (71), and loading means for loading the photosensitive medium on to an auxiliary support surface aligned with the exposure unit.

14. The system according to Claim 13, further including:

developing means for developing an exposed photosensitive medium, and auxiliary transport means for transporting the exposed photosensitive medium to the developing means.

15. The system according to Claim 10, wherein the source of laser light (71) is a laser diode.

16. The system according to Claim 10, wherein the source of laser light (71) is a Nd:YAG laser.

17. The system according to any one of claims 7 to 16 wherein:

the writing means (22) comprises a plurality of laser diodes (32), and the reading head (25) comprises an equal number of laser diodes (41) each of which is co-ordinated with a corresponding laser diode in the writing means (22).

**Patentansprüche**

1. Verfahren zum Plotten auf einen direkt beschreibbaren Film, insbesondere zum Herstellen einer Photomaske (72) der Art, bei der elektronisch gespeicherte Referenzdaten auf einen direkt beschreibbaren Film (21) mit einer auf einer transparenten Basis gelagerten Metall/Metallverbindung geplottet werden, um so die Referenzdaten darstellenden Pixeldaten auf den Film zu schreiben, gekennzeichnet durch die Schritte:

   mitlaufendes Lesen der geschriebenen Pixeldaten direkt nachdem dem diese auf den direkt beschreibbaren Film geschrieben wurden; und mitlaufendes Vergleichen der Pixeldaten mit den Referenzdaten, um zu verifizieren, daß der Abbildungsschritt fehlerfrei ist.

2. Verfahren nach Anspruch 1, ferner gekennzeichnet durch den Schritt der Zurückweisung jedes Films, für welchen der Abbildungsschritt nicht als fehlerfrei verifiziert wurde.

3. Verfahren nach Anspruch 1, ferner gekennzeichnet durch die Schritte:

   Erzeugen eines Alarmsignals für jeden Film, für welchen der Abbildungsschritt nicht als fehlerfrei verifiziert wird; und manuelles Entfernen des Films.

4. Verfahren nach Anspruch 1, ferner gekennzeichnet durch die Schritte:

   Erzeugen eines Alarmsignals für jeden Film, für welchen der Abbildungsschritt nicht als fehlerfrei verifiziert wird; und automatisches Entfernen des Films.

5. Verfahren nach einem der vorstehenden Ansprüche, wobei die Abbildung auf den direkt beschreibbaren Film mittels einer Laserdiode aufgebracht wird.

6. Verfahren nach einem der vorstehenden Ansprüche, ferner gekennzeichnet durch die Schritte:

   Belichten einer photoempfindlichen Platte mit Licht, das durch einen vorher hergestellten Film hindurch übertragen wird; und Entwickeln der belichteten photoempfindlichen Platte.

7. System zum Plotten auf einen direkt beschreibbaren Film, insbesondere zum Herstellen einer Photomaske (72) mit:

   einer Referenzeinrichtung (CAD) zum Bereitstellen auf den direkt beschreibbaren Film zu schreibender Referenzdaten; einer zylindrischen Lagerungsfläche (24) zum Lagern eines direkt beschreibbaren Films (23) darauf; einer Schreibeinrichtung (22), die mit der Referenzeinrichtung gekoppelt ist und auf die Referenzdaten reagiert, um Referenzdaten darstellende Pixeldaten auf den direkt beschreibbaren Film zu schreiben; und einer Verschiebungseinrichtung (26), die mit der Schreibeinrichtung (22) verbunden ist, um die Schreibeinrichtung (22) bezogen auf die Lagerfläche und synchron zu deren Drehung zu verschieben; und dadurch gekennzeichnet, daß sie eine Verifikationsanordnung aufweist, mit: einem Lesekopf (25), der mit der Verschiebungseinrichtung (26) gekoppelt ist, zum mitlaufenden Lesen der Pixeldaten direkt nachdem diese von der Schreibeinrichtung geschrieben wurden, wobei der Lesekopf aufweist: eine Laserlichtquelle (41) zum Erzeugen eines Lichtstrahls, und eine Scaneinrichtung (49, 50, 51, 52) zum Scannen des Lichtstrahls über den direkt beschreibbaren Film, um so die geschriebenen Daten zu lesen.

8. System nach Anspruch 7, dadurch gekennzeichnet, daß die Verifikationsanordnung eine Steuereinheit zum Vergleichen der Pixeldaten mit den Referenzdaten aufweist, um so ein Fehlersignal zu erzeugen, wenn die Pixeldaten nicht den Referenzdaten entsprechen.

9. System nach Anspruch 7, dadurch gekennzeichnet, daß die Schreibeinrichtung (22) aufweist:

   eine Abbildungseinrichtung (32) zum Aufbringen einer Abbildung auf den direkt beschreibbaren Film; und einen mit der Referenzeinrichtung und der Abbildungseinrichtung gekoppelten Plotterkopf, um die Abbildungseinrichtung den Referenzdaten entsprechend zu modulieren.

10. System nach Anspruch 9, wobei die Abbildungseinrichtung einer Laserlichtquelle ist.

11. System nach Anspruch 7, wobei die Steuereinheit aufweist:

   einen Schwellenkomparator (58) zum Vergleichen der optischen Dichte des reflektierten Strahls mit entsprechenden niedrigen und hohen Schwellen abhängig davon, ob der Lichtstrahl auf eine dunkle oder durchsichtige Fläche des direkt beschreibbaren Films auftrifft.

**12.** System nach Anspruch 7 oder 8, welche ferner eine Rückweisungseinrichtung aufweist, die mit der Verifikationsanordnung verbunden ist und auf das Fehlersignal reagiert, um automatisch einen fehlerhaften Film zurückzuweisen.

**13.** System zum Herstellen von Leiterplatten (77), mit:

einem System zum Plotten eines direkt beschreibbaren Film nach Anspruch 7;
einem photoempfindlichen Medium (77), auf welches ein Konstruktionsmuster zu übertragen ist;
einer Belichtungseinheit (71) zum Belichten des Photoempfindlichen Mediums durch den Film oder die Photomaske (72) hindurch;
einer Transporteinrichtung zum Transportieren der Photomaske nach deren Herstellung von der Lagerungsfläche (24) zu der Belichtungseinheit (71); und
einer Ladeeinrichtung zum Laden des photoempfindlichen Mediums auf eine zu der Belichtungseinrichtung ausgerichtete Hilfslagerungsfläche.

**14.** System nach Anspruch 13, ferner mit:

einer Entwicklungseinrichtung zum Entwickeln eines belichteten photoempfindlichen Mediums; und
einer Hilfstransporteinrichtung zum Transportieren des belichteten photoempfindlichen Mediums zu der Entwicklungseinrichtung.

**15.** System nach Anspruch 10, wobei die Laserlichtquelle (71) eine Laserdiode ist.

**16.** System nach Anspruch 10, wobei die Laserlichtquelle (71) ein Nd:YAG-Laser ist.

**17.** System nach einem der Ansprüche 7 bis 16, wobei:

die Schreibeinrichtung (22) mehrere Laserdioden (32) aufweist; und
der Lesekopf (25) eine gleiche Anzahl von Laserdioden (41) aufweist, wovon jede einer entsprechenden Laserdiode in der Schreibeinrichtung (22) zugeordnet ist.

**Revendications**

**1.** Procédé de traçage sur film à gravure directe, destiné particulièrement à la fabrication d'un photo-outil (72) du type dans lequel des données de référence, stockées électroniquement, sont tracées sur un film à gravure directe (21) comprenant une couche de composé métal/métal supportée par une base transparente, de façon à écrire des données de pixels sur le film, représentant les données de référence, caractérisé par les étapes de:

lecture des données de pixels écrites en ligne, immédiatement après leur traçage sur le film à gravure directe; et
comparaison des données de pixels en ligne aux données de référence de façon à vérifier si l'étape de formation d'image est exempte d'erreurs.

**2.** Procédé suivant la revendication 1, caractérisé en outre par l'étape d'élimination de tout film pour lequel l'étape de formation d'image n'est pas vérifiée comme étant exempte d'erreurs.

**3.** Procédé suivant la revendication 1, caractérisé en outre par les étapes de

génération d'un signal d'alarme en relation avec tout film pour lequel l'étape de formation d'image n'est pas vérifiée comme étant exempte d'erreurs, et
retrait manuel dudit film.

**4.** Procédé suivant la revendication 1, caractérisé en outre par les étapes de:

génération d'un signal d'alarme en relation avec tout film pour lequel l'étape de formation d'image n'est pas vérifiée comme étant exempte d'erreurs, et
retrait automatique dudit film.

**5.** Procédé suivant l'une quelconque des revendications précédentes, dans lequel l'image est formée sur le film à gravure directe au moyen d'une diode laser.

**6.** Procédé suivant l'une quelconque des revendications précédentes, caractérisé en outre par les étapes d':

exposition d'une plaque photosensible à la lumière transmise à travers un film préfabriqué, et
développement de la plaque photosensible exposée.

**7.** Système de film à gravure directe, destiné particulièrement à la fabrication d'un photo-outil (72), le système comprenant:

des moyens de référence (CAD), destinés à fournir des données de référence à écrire sur le film à gravure directe,

une surface de support cylindrique (24), destinée à supporter un film à gravure directe (23), des moyens d'écriture (22) couplés aux moyens de référence et sensibles aux données de référence, pour écrire des données de pixels représentant les données de référence sur le film à gravure directe, et

des moyens de déplacement (26), couplés aux moyens d'écriture, pour déplacer ces moyens d'écriture (22) par rapport à la surface de support, en synchronisme avec la rotation nécessaire à celle-ci;

ledit système étant caractérisé en ce qu'il comprend un ensemble de vérification comprenant: une tête de lecture (25) couplée aux moyens de déplacement (26) pour lire les données de pixels en ligne immédiatement après leur écriture par les moyens d'écriture, ladite tête de lecture comprenant:

une source de lumière laser (41) destinée à générer un faisceau lumineux et

des moyens de balayage (49, 50, 51, 52) destinés à assurer le balayage du faisceau lumineux sur le film à gravure directe, de façon à lire les données écrites.

8. Système suivant la revendication 7, caractérisé en ce que l'ensemble de vérification comprend un contrôleur pour comparer les données de pixels aux données de référence, de façon à générer un signal d'erreur si les données de pixels ne correspondent pas aux données de référence.

9. Système suivant la revendication 7, caractérisé en ce que lesdits moyens d'écriture (22) comprennent:

des moyens de formation d'image (32), destinés à former une image sur un film à gravure directe, et

une tête de traçage couplée aux moyens de référence et aux moyens de formation d'image pour moduler les moyens de formation d'image conformément auxdites données de référence.

10. Système suivant la revendication 9, dans lequel lesdits moyens de formation d'image consistent en une source de lumière laser.

11. Système suivant la revendication 7, dans lequel le contrôleur comprend:

un détecteur à seuil (58) pour comparer la densité optique du faisceau réfléchi à des seuils bas et haut respectifs, suivant que le faisceau lumineux atteint une zone sombre ou une zone claire du film à gravure directe.

12. Système suivant l'une des revendications 7 ou 8, comprenant en outre des moyens d'élimination couplés à l'ensemble de vérification et sensibles au signal d'erreur, destinés à l'élimination automatique d'un film défectueux.

13. Système destiné à la fabrication de cartes imprimées (77), comprenant:

un système de traçage de film à gravure directe suivant la revendication 7,

un support photosensible (77) sur lequel un motif doit être transféré,

une unité d'exposition (71), pour exposer le support photosensible à travers le film ou photo-outil (72),

des moyens de transport pour transporter le photo-outil, après la fabrication de celui-ci, de la surface de support (24) à l'unité d'exposition (71), et

des moyens de chargement pour charger le support photosensible sur une surface de support auxiliaire, alignée avec l'unité d'exposition.

14. Système suivant la revendication 13, comprenant en outre:

des moyens de développement pour développer un support photosensible exposé, et

des moyens de transport auxiliaires pour transporter le support photosensible exposé vers les moyens de développement.

15. Système suivant la revendication 10, dans lequel la source de lumière laser (71) est une diode laser.

16. Système suivant la revendication 10, dans lequel la source de lumière laser (71) est un laser Nd:YAG.

17. Système suivant l'une quelconque des revendications 7 à 16, dans lequel:

les moyens d'écriture (22) comprennent une pluralité de diodes laser (32), et

la tête de lecture (25) comprend un nombre égal de diodes laser (41), coordonnées chacune à une diode laser correspondante dans les moyens d'écriture (22).

Block diagram

Fig.1

cad → plotter and verification unit

DWFs feeder → plotter and verification unit

laminator and boards autoloader → exposure and projection device

turn over → exposure and projection device

1st pass?  y / n

n → developer

EP 0 426 523 B1

Fig. 2

10

Fig. 3

Fig. 4

VI →

26    65    63

VI →

24

Fig.5

62

61    63

60

26

64    64

65

Fig.6

EXPOSURE DEVICE

Fig.7